# EUROPEAN PATENT SPECIFICATION

(11) **EP 1 193 815 B1**
(45) Date of publication and mention of the grant of the patent: **10.05.2006**
(21) Application number: 01123211.3
(22) Date of filing: 01.10.2001
(51) Int. Cl.: H01S 5/34

(54) **Semiconductor laser device and optical fiber amplifier using the same**
Halbleiterlaser und optischer Faserverstärker, der selbigen benutzt
Laser à semiconducteur et son utilisation dans un amplificateur à fibre optique

(30) Priority: 02.10.2000 JP 2000302956; 08.06.2001 US 877952
(43) Date of publication of application: 03.04.2002
(73) Proprietor: FURUKAWA ELECTRIC CO., LTD., Tokyo (JP)
(72) Inventor: Yoshida, Junji, Chiyoda-ku, Tokyo (JP); Tsukiji, Naoki, Chiyoda-ku, Tokyo (JP); Saito, Tsuyoshi, Chiyoda-ku, Tokyo (JP); Irino, Satoshi, Chiyoda-ku, Tokyo (JP); Minato, Ryuichiro, Chiyoda-ku, Tokyo (JP)
(74) Representative: Modiano, Micaela Nadia

(56) References cited:
- EP-A- 0 403 153
- EP-A- 0 500 962
- US-A- 4 881 235
- US-A- 5 889 805
- TANAKA T ET AL: "UNIFORM P-TYPE IMPURITY-DOPED MULTIQUANTUM WELL ALGAINP SEMICONDUCTOR LASERS WITH A LASING WAVELENGTH OF 633 NM AT 20 C" APPLIED PHYSICS LETTERS, AMERICAN INSTITUTE OF PHYSICS. NEW YORK, US, vol. 59, no. 16, 14 October 1991 (1991-10-14), pages 1943-1945, XP000257411 ISSN: 0003-6951
- RALSTON J D ET AL: "P-DOPANT INCORPORATION AND INFLUENCE ON GAIN AND DAMPING BEHAVIOUR IN HIGH-SPEED GAAS-BASED STRAINED MQW LASERS" MATERIALS SCIENCE AND ENGINEERING B, ELSEVIER SEQUOIA, LAUSANNE, CH, vol. B21, no. 2/3, 20 November 1993 (1993-11-20), pages 232-236, XP000414108 ISSN: 0921-5107
- TANAKA T ET AL: "FREQUENCY CONTROL OF SELF-SUSTAINED PULSATING LASER DIODES BY UNIFORM IMPURITY DOPING INTO MULTIPLE-QUANTUM-WELL STRUCTURES" IEEE PHOTONICS TECHNOLOGY LETTERS, IEEE INC. NEW YORK, US, vol. 10, no. 1, 1998, pages 48-50, XP000737122 ISSN: 1041-1135

## Description

### FIELD OF THE INVENTION

The present invention relates generally to semiconductor laser devices of the type having an active layer (light emitting region) with a multiple quantum well ("MQW") structure. More particularly, this invention relates to MQW semiconductor laser devices with higher carrier injection efficiency and enhanced light output. The invention also relates to optical fiber amplifiers employing the same.

### BACKGROUND OF THE INVENTION

Semiconductor laser devices having an active layer (light emitting region) employing a multiple quantum well structure are known in the art. Such devices emit light at lower threshold currents than semiconductor laser devices having a bulk active layer, and have a higher optical output power.

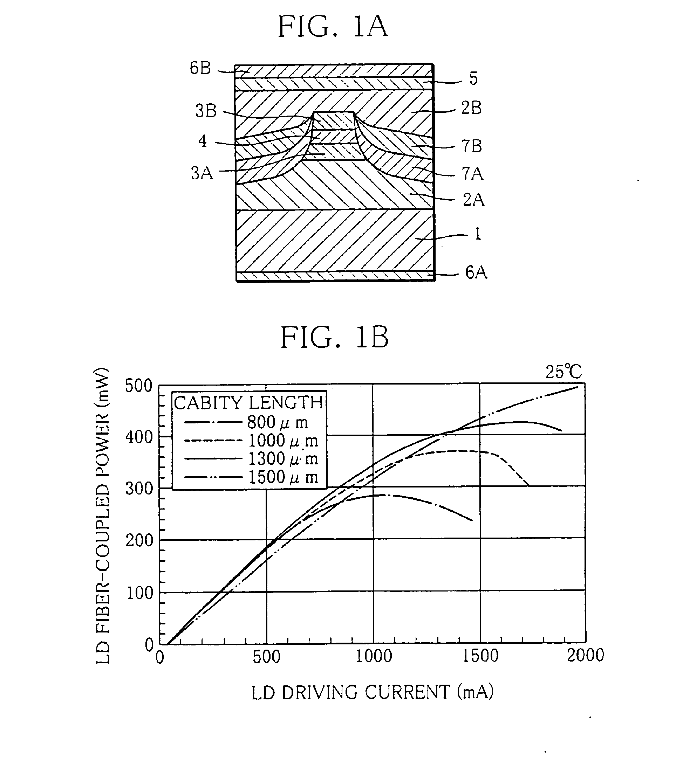

An example of a known MQW laser device is shown in cross-section in FIG. 1. The laser device depicted in FIG. 1 comprises a number of semiconductor layers which are formed using known techniques on a semiconductor substrate 1, which in the example depicted is an n-type semiconductor. The various layers include: an n-type lower cladding layer 2A, a undoped lower optical confinement layer 3A, an active layer 4, a undoped upper optical confinement layer 3B, a p-type upper cladding layer 2B, and a p-type cap layer 5. These layers are sequentially formed on the substrate 1 by any of a number of known epitaxial crystal growth techniques such as, for example, metal organic chemical vapor deposition (MOCVD). An n-type lower electrode 6A is also formed on the lower side of substrate 1 and a p-type upper electrode is formed over cap layer 5. As depicted in FIG. 1, active layer 4 and the adjacent optical confinement layers 3A and 3B are formed into an elongated mesa structure using standard photolithographic techniques. Current blocking p-type semiconductor layer 7A and n-type semiconductor layer 7B are then formed in the region adjacent to the mesa structure, so that, in operation, current is injected into active layer 4 in a narrow area.

The resulting structure is then cleaved to provide a laser having a predetermined resonator length (L). The front facet S1, used as a light output, is formed on one cleaved plane through fabrication of a low reflectivity film, and the rear facet S2 is formed on the opposite facet of the cavity with a high reflectivity film.

It is known that the active layer 4 may be designed to have a MQW structure consisting essentially of alternate heterojunctions of well layers made of semiconductor material. Each hetero-junction comprises a pair of semiconductor layers: a well layer of a narrow band gap energy and a barrier layer. The barrier layer has a band gap energy which is wider than that of the well layers. Each of the various sub-layers in the MQW structure has a thickness of several nanometers

Lower and upper optical confinement layers 3A and 3B adjacent to active layer 4 are each designed to have a separate confinement heterostructure (SCH), in order to enhance the confinement of the laser light created in active layer 4, thereby enhancing the external differential quantum efficiency of the laser to achieve high optical output power operation.

It is also known in the art that the semiconductor laser device of FIG. 1 may be secured in a package to form a laser module which is suitable for use as signal light source in an optical communications system, or as a light source for pumping an optical fiber amplifier such as an erbium-doped fiber amplifier (EDFA). Within the package, the laser device may be thermally coupled to a cooling device comprising Peltier elements. The package may also include and other known structures to monitor and control heat generation and light output, and to ensure good optical coupling of the laser output to an optical fiber.

In recent years, the rapid growth in the Internet and other communications systems has led to the development of fiber-optic wavelength division multiplexing (WDM) system architectures to provide increased data transmission capacity in such systems.

In order to provide optical fiber amplifiers with enhanced light output performance to meet the demand for an increased number of channels, there has been a need for pumping lasers with high light output coupled to the optical fiber. Pumping lasers for optical fiber amplifiers are required to offer stable operation with ever higher fiber-coupled light output and with narrower spectral width, especially for use in optical fiber Raman amplifiers.

One way to achieve a high light output pumping laser with an MQW active layer is to increase the resonator length (L).

Increasing the resonator length decreases both the electric resistance and thermal impedance of the laser device. This results in a larger saturation driving current *I*ₛₐₜ at which the maximum optical output power occurs, since the saturation is dominated by thermal saturation effects. However, for a given value of output facet reflectivity, increasing L lowers causes the external differential quantum efficiency to lower, due to the lowering of mirror loss ratio against the total loss. Thus, at very long cavity lengths the maximum light output tends to saturate, due to the trade-off between the saturation driving current and the external differential quantum efficiency.

This problem can be ameliorated to some degree by reducing the reflectivity of the output facet. However, lowering the reflectivity of the output facet of the laser device below a certain value results in deterioration of the differential quantum efficiency of the device and causes the saturation of maximum optical output power. Reported mechanisms for such deterioration include carrier leakage from the MQW structure to the optical confinement and cladding layers, increased optical absorption loss and recombination carrier loss at the confinement layers due to the carrier leakage and non-uniform hole injection into the MQW structure.

The graded index, separate confinement heterostructure (GRIN-SCH) is known to be effective in suppressing deterioration in low power short cavity lasers, where continuous GRIN or multi-layer GRIN structure have been reported. However, for high power lasers, the reported results has been limited only to two-step GRIN structures, and the results have been found to be insufficient.

A proposed approach to attaining higher light output from a semiconductor laser device having an MQW active layer is to employ undoped well layers sandwiched between barrier layers having an n-type dopant, e.g., selenium (Se) or sulfur (S). This so-called "modulation-doping" of the barrier layer suppresses internal absorption by of the MQW structure thereby enabling higher light output operation. However, when using MOCVD, it is very difficult to fabricate this type of modulation-doped structure within the active layer, because of the need for selective doping of an n-type dopant into only the barrier layer. For example, in cases where the n-type dopant is sulfur, the sulfur will diffuse from the barrier layers into the adjacent well layers at the temperatures used during device formation.

Likewise, when using selenium, the well-known memory effect causes selenium to be incorporated into the well layers during the growth process. While a complete interruption of crystal growth process can be used to realize the intended abrupt doping profile with Se, such interruptions can cause degrade the interfaces between well layers and the adjacent barrier layers, increasing the number of nonradiative recombination centers and, thereby, limiting the optical output of the device.

Tanaka T. et al. disclosed a semiconductor laser device according to the pre-characterizing portion of claim 1 in the publication entitled "Uniform *p*-type impurity-doped multiquantum well AlGaInP semiconductor lasers with a lasing wavelength of 633 nm at 20°C", *Appl. Phys. Lett.* 59(16), 14 October 1991.

### SUMMARY OF THE INVENTION

It is therefore a primary object of the present invention to provide a new and improved semiconductor laser device which avoids the foregoing problems which limit high light output operation of such a device. The laser device of the present invention is particularly useful as an optical fiber amplifier pumping light source having high carrier injection efficiency.

The invention is able to achieve high carried injection efficiency without increasing the unavailable currents and is capable of enhanced light output compared to other laser devices having an MQW structure.

To attain the foregoing object, the present invention comprises a semiconductor laser device according to claim 1. Preferably, the semiconductor laser device has a resonator length of more than 800 µm with a cladding layer disposed on an optical confinement layer which is in contact with an MQW active layer having multiple well layers and multiple barrier layers, wherein an impurity is doped into at least one well layer within the active layer and at least one barrier layer adjacent to the well layer and wherein the thickness of the optical confinement layer falls within a range of from 20 to 50 nm.

The present invention also provides an optical fiber amplifier pumping device comprising the above semiconductor laser device mounted within a package containing a cooling unit, wherein an optical fiber is coupled to the optical output facet of the semiconductor laser device.

### BRIEF DESCRIPTION OF THE DRAWINGS

FIG. 1 is a cross-sectional view of a semiconductor laser device.
FIG. 2 is an energy band diagram showing the bad gap energies of the MQW active layers and the adjacent optical confinement and cladding layers in a laser structure according to one embodiment of the present invention.
FIG. 3 is an energy band diagram showing the band gap energies for the layers between a cladding layer and barrier layer in accordance with an embodiment of the present invention.
FIG. 4 is a cross-sectional schematic diagram of an exemplary laser module of the present invention.
FIG. 5 is a graph showing maximum laser optical output power (Pₘₐₓ) as a function of the selenium doping concentration in the active MQW layer of the present invention .
FIG. 6 is a graph showing the maximum optical output power (Pₘₐₓ) as a function of the thickness of the optical confinement layer in a exemplary laser device structure.
FIG. 7 is a graph showing the maximum optical output power (Pₘₐₓ) as a function of the energy difference between band gap energy for the outermost optical confinement layer (E₂) and for the inner most optical confinement layer (E₁) in an exemplary laser structure.
FIG. 8 is a graph showing the saturation current as a function of the energy difference between band gap energy for the outermost optical confinement layer (E₂) and for the inner most optical confinement layer (E₁) in an exemplary laser structure.

### DETAILED DESCRIPTION

In one aspect, the present invention is directed to a laser structure (also referred to as a laser device) having the capacity to produce a high powered optical output.

The laser device of the present invention preferably has the layer structure depicted in the exemplary cross-sectional schematic diagram of FIG. 1, which has been previously described. Multiple quantum well (MQW) structure of active layer 4 of the present invention (not depicted in FIG. 1) is sandwiched between adjacent optical confinement layers 3A and 3B. In connection with the desire to produce a high output laser, the present invention is particularly useful with laser devices, of the type depicted in FIG. 1, having a resonator cavity length (L) of 800 µm or greater.

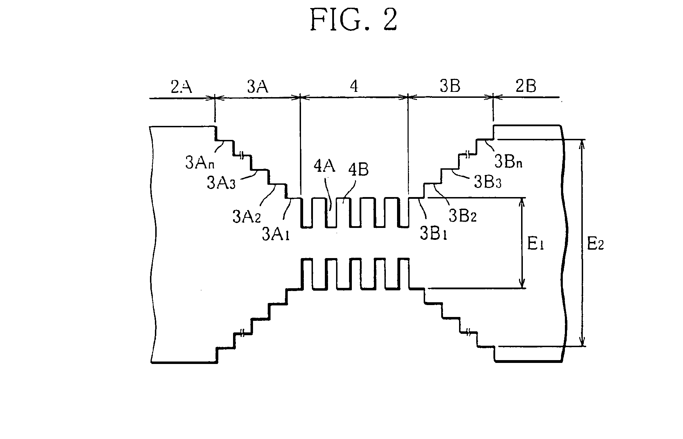

An exemplary energy band diagram of the conduction and valence bands of a laser device of the present invention is shown in FIG. 2. FIG. 2 shows the band gap between the conduction and valence bands, depicting a lower optical confinement layer 3A, an active layer 4, an upper optical confinement layer 3B and an upper cladding layer 2B which have been formed on lower cladding layer 2A in that order. As depicted in FIG. 2, active layer 4 comprises alternate heterojunctions of well layers 4A and barrier layers 4B, thereby providing an MQW structure having five wells. Optical confinement layers 3A and 3B, positioned between active layer 4 and cladding layers 2A, 2B are preferably formed in such a manner that their respective composition and thickness are symmetrical about active layer 4. Each of the optical confinement layers 3A, 3B has a plurality of steps in their respective energy bands, as shown in FIG. 2. Thus, in the embodiment of FIG. 2, optical confinement layer 3B has two sublayers 3B₁ and 3B₂. In order to achieve the preferred symmetrical construction of the device, optical confinement layer 3A has two corresponding sublayers, 3A₁ and 3A₂.

As depicted in FIG. 2, the band gap is smallest in the wells of the MQW structure of active layer 4, is greater at the barrier layers in the MQW, is still greater in the optical confinement layers, and is greatest at the cladding layers.

A first principal feature of the laser device of the present invention is that a dopant is incorporated into at least one well layer 4A of the active layer 4 and its adjacent barrier layer 4B to thereby form a doped region 8. Although FIG. 2 depicts doped region 8 as having only a one barrier layer and one well, according to the present invention doped region 8 may extend to any number of pairs of well layers and barrier layers. Indeed, according to the present invention the entire active layer may be included in doped region 8. The inventors have determined that extending the doped region to the entire active layer 4 reduces the series resistivity and thermal resistivity of the laser device. In this manner, the device's thermal impedance and heat generation are reduced, permitting increased maximum light output.

The dopant used to form doped region 8 is preferably an n-type impurity, such as S, Se and Si (silicon) or combinations thereof. Preferably the doping concentration is set within a range of about from 1 x 10¹⁷ to 3 x 10¹⁸ cm⁻³. The inventors have found that if the doping concentration is below about 1 x 10¹⁷cm⁻³ then the aforementioned benefits of creating doped region 8 in active layer 4 are not obtained, such that the intended enhancement in light output is not realized. On the other hand, the inventors have found that if the dopant concentration is above about 3x10¹⁸cm⁻³ then the crystallinity of active layer 4 can be degraded causing non-radiative components to likewise increase. This impairs the operation of the resulting laser device.

Although an n-type dopant is preferred, the dopant used in the present invention may alternatively be a p-type dopant. The p-type impurity in such case may be any one of beryllium, magnesium or zinc or combinations thereof.

Another important feature of the laser device of this invention is that the two optical confinement layers 3A, 3B shown in FIG. 2 are specifically arranged so that the thickness of each is set to fall within a range of 20 to 50nm. If the thickness of optical confinement layers 3B, 3A is reduced to less than 20nm then resultant light output can reach saturation due to overflow of electrons. On the other hand, if the thickness of optical confinement layers 3B, 3A is increased above 50nm or greater then the resulting DC resistance of the laser device increases. This causes increased heat generation which, in turn, causes light output saturation due to thermal saturation.

Optical confinement layers 3B, 3A form heterojunctions with the respective barrier layers 4B positioned at the outermost part of active layer 4. Similarly, the optical confinement layers also form heterojunctions with upper and lower cladding layers 2B and 2A. Preferably, the band gap energy at the heterojunctions with cladding layers 2B and 2A is greater than the band gap energy at the heterojunctions between the outermost well layer 4A and its neighboring outermost barrier layer 4B within active layer 4. More preferably, the difference between the band gap energy E₁ of such barrier layer and the maximal band gap energy E₂ of optical confinement layer is about 90meV or more, as shown in FIG. 2.

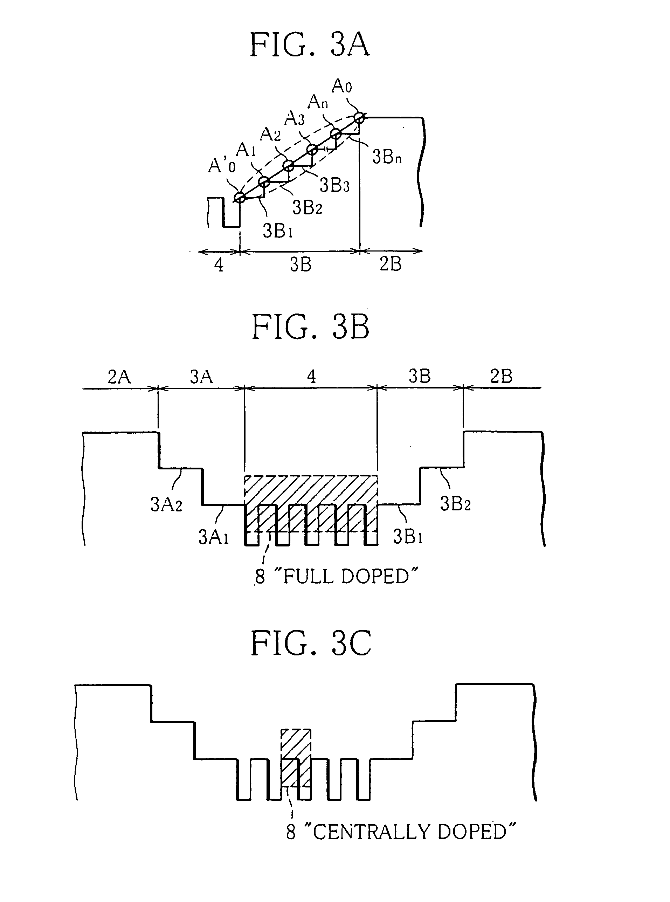

As shown in FIG. 2, optical confinement layers 3A and 3B preferably comprise two or more sublayers, for example, sublayers 3B1, 3B2 and 3A1, 3A2. According to the present invention, the band gap energies of these respective sublayers increase in stepwise fashion as the distance from active layer 4 increases, as shown in FIGS. 2 and 3. FIG. 3 shows a series of points, A1, A2, A0 at the edges of the steps in the band gap of optical confinement layer 3B formed by the sublayers 3B1 and 3B2. Note that the point A0 is formed at the step between optical confinement sublayer 3B2 and the adjacent cladding layer 2B. Also depicted in FIG. 3 is the point A0' which is located at the step in band gap energy between barrier layer 4B and the adjacent well layer 4A. The points A0', A1, A2 and A0 define an envelope line of the band gap energies of the layers, (this envelope line will be referred to hereafter as band gap energy line). Preferably, this band gap energy line is a straight or has a continuous upward or downward convex shape as shown by broken lines in FIG. 3. The upward or downward convex shape may be, for example, parabolic.

Thus, in the case of FIG. 3, the band gap energy line intersects the band gap energy of layer 3B2 at a point A2, such that the band gap energy line has a straight line shape as a whole. In this case, optical confinement layer 3B is said to have a linear GRIN-SCH structure.

As previously noted, optical confinement layers 3A and 3B are not limited only to the exemplary two-layer structure depicted in FIGS. 2 and 3. Increasing the number of sublayers is preferred. However, increasing the number of layers requires careful control of composition of each layer - if even one of them goes out of specified lattice matching conditions then crystal degradation can occur due to crystal defects, which in turn may degrade laser performance. Additionally, increasing the number of sublayers results in an increase in number of crystal growth process steps, increasing the difficulty of mass-production. In light of these issues, it is presently preferred that the number of sublayers be set to at about five (5) or six (6), which are preferably arranged so that their respective band gap energies being fall on the band gap energy line described above.

Preferably the laser device of the present invention is formed such that its well layer 4A has compressive strain of between about 0.5% to about 1.5% with respect to the substrate 1.

As noted above, it is preferred that the laser device of the present invention have resonator length (L) of about 800 µm or more. More preferably, L is greater than about 1000 µm. When the resonator length is less than about 800im the laser device has greater electrical resistivity and thermal-impedance, lowering in saturation current, (since thermal saturation dominates the saturation current). Thus, when the resonator length is less than about 800 im, the benefits of the present invention are not fully realized. When using a relatively long resonator cavity, *i.e.*, resonator cavity of about 800 *µ*m or more, it is preferable that reflectivity of the front facet of the laser device be about 5% or less and that the reflectivity of the rear facet be about 90% or greater. Applying a low-reflectivity film on the front facet of the laser device compensates for the decrease in efficiency which would otherwise occur due to reduced ratio of mirror loss against total losses caused by the use of an elongated resonator. This makes it possible to suppress overflow of carriers created, thereby overcoming the problem of reduced optical output power reduction at high drive current when compared to prior art structures.

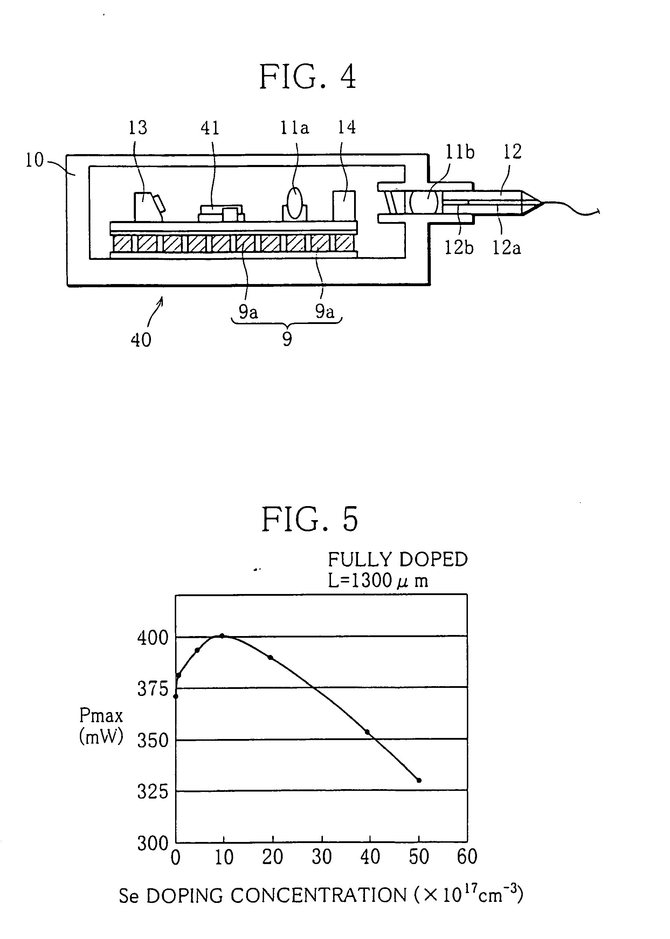

Next, an exemplary laser component of the present invention is described with reference to FIG. 4. The laser component 40 has a laser device 8 sealed within a package 10. Laser device 8 is mounted on a cooling device 9 comprising a plurality of Peltier elements 9a. A collimator lens 11a is disposed adjacent to the output facet of the laser device 8 and a light collection or focusing lens 11b is positioned near a wall of package 10. An optical fiber 12 is positioned at the front of the package 10 adjacent to lens 11b, such that the light emitted by laser device 8 is coupled to fiber 12. A photodiode 13 is disposed adjacent to the rear facet of the laser device 8 to monitor the light output from the device.

Preferably, optical fiber 12 has an optical fiber grating 12b formed in its central core 12a. Preferably, the reflection bandwidth of fiber grating 12b is set at about 3nm or less. More preferably, the reflection bandwidth of the fiber grating is set about 2nm or less, and even more preferably it is set at about 1.5 nm or less . However, the reflection band width of fiber grating 12b should be greater than the wavelength separation of the longitudinal modes in the light from the laser device 8.

Setting the grating bandwidth in this manner reduces or eliminates kinks in the current versus light output characteristics of laser light from the optical fiber 12, while simultaneously narrowing the spectrum width of the light to enable enhanced multiplexing. In the module shown in Fig.4, present invention realizes a higher output power and more stable operation due to broader gain bandwidth.

### Example

A plurality of semiconductor laser devices according to the present invention having wavelength of 1480nm and the layer structure shown in FIG. 1 were manufactured in the following manner, and the relation of the parameters versus laser characteristics were analyzed while changing various parameters of the devices which were constructed.

### Influence of impurity doping into active layer.

An n-type cladding layer 2A comprised of n-type InP was fabricated on the (100) plane of a substrate 1 made of n-type InP. A lower optical confinement layer 3A was formed on this lower cladding layer 2A. The optical confinement layer 3A was made of undoped InGaAsP-based semiconductor material with a GRIN-SCH structure as follows: First, a layer 3A2 made of InGaAsP (ëg=1.1 µm having a thickness of 20ìm was formed; then, a layer 3A1 made of undoped InGaAsP (ëg=1.2 µm) was formed thereon to a thickness of 20nm. An active layer 4, described in detail below, was then formed on this lower optical confinement layer 3A. Next an upper optical confinement layer 3B was formed thereon, comprising a layer 3B1 made of undoped InGaAsP (ëg=1.2 *µ*m with a thickness of 20nm and a layer 3B2 made of undoped InGaAsP ( ëg= 1.1 *µ*m) with a thickness of 20nm. Thus, the upper and lower optical confinement layers were made to be symmetrical about the active layer.

Active layer 4 was formed with five wells 4A made of GaInAsP each having a thickness of 4nm. Each of the well layers was surrounded by a barrier layer 4B made of GaInAsP with a thickness of 10nm. The overall MQW active layer structure was formed to have a compressive strain of 1% as a whole. An n-type dopant Se was incorporated into the layers of the MQW active layer to form an impurity-doped region 8 arranged as discussed below. A first set of devices was created having doping in all of the MQW layers (referred to as the "fully doped" herein) with a dopant concentration of 1 x 10¹⁷cm⁻³ in all of the well layers 4A and barrier layers 4B. A second set of devices was created with doping only in a pair consisting of a centrally located well layer 4A and an adjacent barrier layer 4B (referred to hereinafter as "centrally doped") with a dopant concentration of 5 x 10¹⁷ cm⁻³. In addition, a set of devices was created having an undoped active layer 4 as a comparative example (referred to as "undoped" hereinafter).

Thereafter, mesa were formed on the devices using standard photolithographic and etching techniques and a p-type current blocking layer 7A and n-type current blocking layer 7B for current constriction were formed in the area adjacent to the resulting mesas. An upper cladding layer 2B made of p-type InP was then formed on the upper optical confinement layer 3B, and a contact layer 5 made of p-type InGaAs was formed thereon. A p-type upper electrode 6B was then formed on contact layer 5 and the back surface of substrate 1 was polished. An n-type electrode 6A the formed on the resulting polished surface.

The resulting structures were then cleaved to set the resonator length (L) at 1000 µm, and a low reflectivity film (reflectivity of 1%) was formed on the front facet S1 and a high reflectivity film (reflectivity of 95%) was formed on the rear facet S2 to complete the fabrication of the laser devices.

With regard to the laser devices of three different types, the maximum light output (Pmax) during current driving was measured. Results thus obtained are shown in Table 1 below.

**Table 1**

| Impurity Doped Region at Active Layer | Pmax (Relative Value) |
|---|---|
| Fully Doped | 1.2 |
| Centrally Doped | 1.07 |
| Undoped | 1.0 |

Table 1 compares the maximum optical output power Pmax for three types of LDs with different doping conditions and with cavity length 1000 um. From Table 1 it can be seen that if all of the well layers and barrier layers of the active layer are doped, high light output operation is achieved.

Next, for fully doped devices, the relationship between Pmax and the level of n-type (Se) doping concentration was investigated. The laser devices used for this investigation had the same in structure as described above, except that their resonator length (L) was set at 1300 µm. The results are shown in FIG. 5.

As shown in FIG. 5, the value of Pmax reaches a distinct maxima which, for the devices investigated is about 400mW when the Se doping concentration is set at 1 x 10¹⁸cm⁻³. At lower or higher dopant concentrations, the effect of doping comparatively decreases. Thus, according to the present invention the value of doping concentration in the active layer is set to maximize Pmax.

### Influence of thickness of GRIN-SCH structure

Laser devices were then manufactured with the same in structure as has been discussed previously except that the structure of their GRIN-SCH optical confinement layers were varied to investigate how differences in thickness affected the laser output. As described, the upper optical confinement layer 3B and the lower optical confinement layer 3A were comprised of a two-layer structure of having sublayers 3B1, 3B2 and 3A1, 3A2, respectively. For this investigation, the active layers were fully doped (Se doping concentration 1 x 10¹⁸cm⁻³).

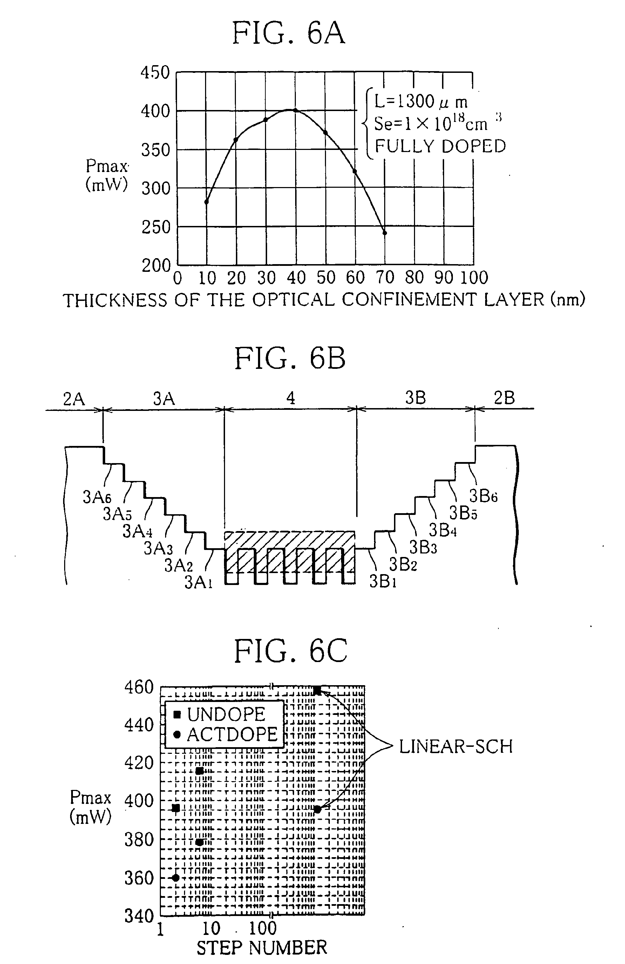

The value of Pmax of the resulting laser devices was measured and the results are shown in FIG. 6. Again, the data show a fairly distinct maxima at around 400mw for an optical confinement layer thickness of about 40nm. FIG. 6 also shows that high optical output power operation of more than 360mW was obtained when the thickness of the optical confinement layer was in the range of about 20 to 50nm.

### Influence of band gap energy difference between the outermost optical confinement layer (E₂) and the inner most optical confinement layer (E₁).

Fully doped laser devices were then manufactured with the same structure previously described, but with the resonator length (L) being set at 1300 im and with the concentration of Se doping of the active layer being set at 5 x 10¹⁷cm⁻³, in order to investigate the effect of the band gap energy difference (E₂-E₁) between the outer most optical confinement layer and for the inner most optical confinement layer. Additionally laser devices with E₂ - E₁ = 0 were also manufactured.

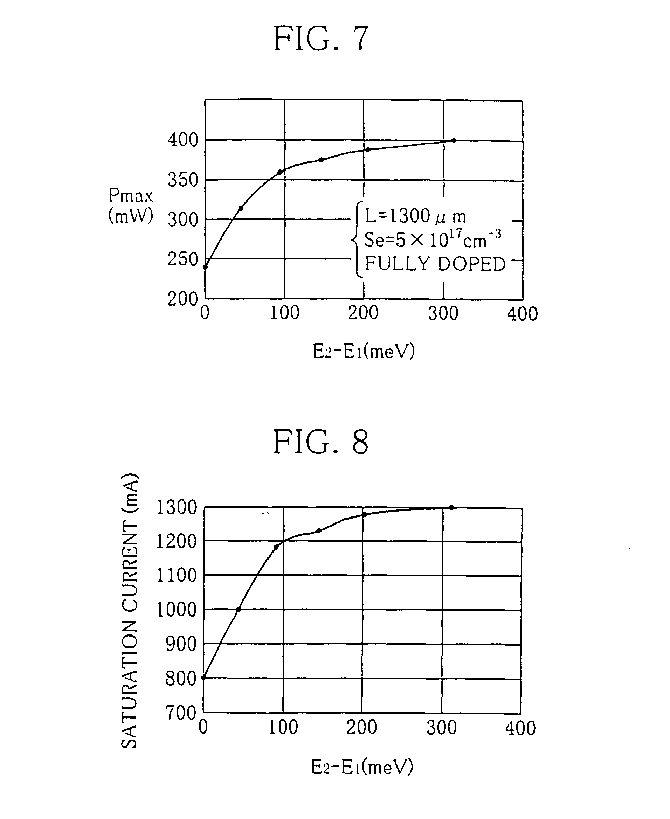

Pmax values of these laser devices were measured and the results are shown in FIG. 7. The optical output power versus current characteristics of the laser devices were also analyzed to determine the saturation output current, and the resultant values are shown in FIG. 8, in the form of a graph of the saturation current as a function of the value of E2 - E1. FIG. 7 shows that the light output increases with an increase in the value of E₂ - E₁. When the value of E₂ - E₁ is about 90meV or more, light output of more than 360mW was obtained. In the devices investigated, saturation occurred at about 400mW. FIG. 8 shows that a laser device having an E₂- E₁ of 90meV has a saturation output current greater than about 1200 mA, thereby enabling driving with large injection currents, which, in turn, makes it possible to attain a high maximum light output.

Although the exemplary embodiments used laser devices of 1480 nm, it will be apparent to those skilled in the art that the present invention is not limited to such lasers. In particular, it will be appreciated that the devices of the present invention will also be particularly useful with Raman amplifying light sources of 1200 to 1550nm.

Also, although the present invention has been explained with respect to an exemplary GaInAsP-based laser device on InP substrate, it will be apparent to those skilled in the art that the invention is not limited to such a structure; for example, the invention has application to an AlGaInAsP-based laser device on InP substrate and to AlGaInP or AlGaInNAsP or GaInAsP-based laser devices on GaAs substrates. Furthermore, those skilled in the art will appreciate that the substrate may be modified to p-type substrate.

The laser device of the present invention is high in carrier injection efficiency and also in optical confinement effect of optical confinement layers while offering enhanced optical output power and thus is successfully adaptable for use as a light source for pumping optical fiber amplifiers. Accordingly, the laser device of the present invention is particularly well suited for use as a light source for use in advanced systems under strict requirements of W-class optical output power performance, such as, for example, erbium-doped optical fiber amplifiers and/or fiber Bragg grating-coupled Raman amplifiers.

While the present invention has been described in respect to particular embodiments thereof, those skilled in the art will appreciate that other changes and modifications may be made without departing from the scope of the invention. Therefore, the invention should be construed to be limited only by the following claims.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A semiconductor laser comprising:
an active light-emitting layer (4) having a multi-quantum well structure comprising a plurality of individual semiconductor well layers (4A) formed between adjacent semiconductor barrier layers (4B), at least one of said well layers (4A) and at least one of said adjacent barrier layers (4B) being doped, and
upper (3B) and lower (3A) optical confinement layers adjacent to said active layer (4),
**characterized in that** said multi-quantum well structure has a cavity length (L) greater than about 800 µm and the thickness of each of said optical confinement layers (3A, 3B) is between 20 to 50 nm.

2. The semiconductor laser of claim 1 wherein said at least one of said well layers (4A) and at least one of said adjacent barrier layers (4B) is doped with an n-type dopant.

3. The semiconductor laser of claim 1 wherein said at least one well layer (4A) and said at least one barrier layer (4B) is doped with an n-type dopant at a concentration of about 1 x 10¹⁷ to about 3 x 10¹⁸ cm⁻³.

4. The semiconductor laser of claim 3 wherein said n-type dopant is selected from the group consisting of selenium, sulfur and silicon.

5. The semiconductor laser of claim 1 wherein the cavity length (L) is greater than about 1000 µm.

6. The semiconductor laser of claim 1 wherein a plurality of well layers (4A) and adjacent barrier layers (4B) are doped with an n-type dopant.

7. The semiconductor laser of claim 6 wherein all of the well layers (4A) and all of the barrier layers (4B) are doped with an n-type dopant.

8. The semiconductor laser of claim 1 wherein said optical confinement layers (3A, 3B) comprise a plurality of sublayers (3An, 3Bn) having different band gap energies.

9. The semiconductor laser of claim 8 wherein the band gap energy increases in step-wise fashion from the active layer (4) to the distal surface of the adjacent optical confinement layer (3A, 3B).

10. The semiconductor laser of claim 9 further comprising upper and lower cladding layers (2A, 2B) formed adjacent to said optical confinement layers, wherein the band gap energy of the cladding layers (2A, 2B) is greater than the band gap of both the active layer (4) and the adjacent optical confinement layers (3A, 3B).

11. The semiconductor laser of claim 10, wherein the band gaps energy at the boundaries (A0', A1, A2, A0) between the various adjacent layers define a band gap envelop, and wherein said band gap envelop is a straight line.

12. The semiconductor laser of claim 10, wherein the band gaps energy at the boundaries (A0', A1, A2, A0) between the various adjacent layers define a band gap envelop, and wherein said band gap envelop is a convex line.

13. The semiconductor laser of claim 12 wherein said convex line is substantially parabolic.

14. The semiconductor laser of claim 1 wherein the well layers (4A) have a compressive strain of between about 0.5% and 1.5%.

15. The semiconductor laser of claim 1 wherein the output facet (S1) of the laser cavity has a reflectivity of less than about 5%, and the rear facet (S2) has a reflectivity of greater than about 90%.

16. The semiconductor laser of claim 1 wherein the wavelength of the output light is in the range of about 1200 nm to about 1550 nm.

17. A laser component (40) incorporating the semiconductor laser of claim 1, said laser component (40) further comprising at least one lens (11b) for optically coupling the output of said semiconductor laser (8) to the facet of an optical fiber (12) and wherein said semiconductor laser (8) is thermally coupled to a cooling device (9).

18. The laser component of claim 17 wherein said optical fiber (12) has a grating (12b) formed therein, said grating (12b) having a bandwidth of 3nm or less.

19. The laser component of claim 17 wherein said optical fiber (12) has a grating (12b) formed therein, said grating (12b) having a bandwidth of 2nm or less.

20. The laser component of claim 17 wherein said optical fiber (12) has a grating(12b) formed therein, said grating (12b) having a bandwidth of 1.5nm or less.

21. A laser component (40) incorporating the semiconductor laser of claim 1, said laser component further comprising a isolator, one lens (11b) for optically coupling the output of said semiconductor laser (8) to the facet of an optical fiber (12) and wherein said semiconductor laser (8) is thermally coupled to a cooling device (9).

22. A high optical output power semiconductor laser comprising a semiconductor laser according to claim 1, wherein:
said at least one of well layers (4A) and said at least one adjacent barrier layer (4B) are doped with an n-type dopant in a concentration of about 1 x 10¹⁷ to about 3 x 10¹⁸ cm⁻³,
each of said optical confinement layers (3A, 3B) comprises a plurality of sublayers (3An, 3Bn), such that said sublayers (3An, 3Bn) have an band gap energy which increases in step wise fashion from said active layer (4), said optical confinement layers (3A, 3B) being symmetrically disposed about said active layer (4);
upper and lower cladding layers (2A, 2B) formed adjacent to said upper and lower optical confinement layers (3A, 3B), respectively, said upper and lower cladding layers (2A, 2B) having a band gap energy greater than the band gap energy of said adjacent optical confinement layers (3A, 3B);
and wherein said cavity has a antireflective coating having a reflectivity of less than about 5% on a output facet (S1) thereof, and a reflective coating having a reflectivity of greater than about 90% on a rear facet (S2) thereof.

## Patentansprüche

1. Ein Halbleiterlaser, der folgendes umfasst:
eine aktive Licht-emittierende Schicht (4) mit einer Mehrfach-Quantentopf-Struktur, die eine Vielzahl einzelner Halbleiter-Topfschichten (4A) umfasst, welche zwischen angrenzenden Halbleiter-Sperrschichten (4B) geformt sind, wobei mindestens eine der Topfschichten (4A) und mindestens eine der angrenzenden Sperrschichten (4B) dotiert ist, und
obere (3B) und untere (3A) optische Begrenzungsschichten, angrenzend an die aktive Schicht (4),
**dadurch gekennzeichnet, daß** die Mehrfach-Quantentopf-Struktur eine Hohlraum-Länge (L) von mehr als ungefähr 800 µm hat und die Dicke jeder der optischen Begrenzungsschichten (3A, 3B) zwischen 20 bis 50 nm beträgt.

2. Der Halbleiterlaser von Anspruch 1, worin die mindestens eine der Topfschichten (4A) und mindestens eine der benachbarten Sperrschichten (4B) mit einem Dotierungsmaterial des n-Typs dotiert sind.

3. Der Halbleiterlaser von Anspruch 1, worin die mindestens eine Topfschicht (4A) und die mindestens eine Sperrschicht (4B) mit einem Dotierungsmaterial des n-Typs bei einer Konzentration von ungefähr 1 x 10¹⁷ bis ungefähr 3 x 10¹⁸ cm⁻³ dotiert sind.

4. Der Halbleiterlaser von Anspruch 3, worin das Dotierungsmaterial des n-Typs gewählt ist aus der Gruppe bestehend aus Selen, Schwefel und Silizium.

5. Der Halbleiterlaser von Anspruch 1, worin die Hohlraum-Länge (L) mehr als ungefähr 1000 µm beträgt.

6. Der Halbleiterlaser von Anspruch 1, worin eine Vielzahl von Topfschichten (4A) und angrenzenden Sperrschichten (4B) mit einem Dotierungsmaterial des n-Typs dotiert sind.

7. Der Halbleiterlaser von Anspruch 6, worin alle Topfschichten (4A) und alle Sperrschichten (4B) mit einem Dotierungsmaterial des n-Typs dotiert sind.

8. Der Halbleiterlaser von Anspruch 1, worin die optischen Begrenzungsschichten (3A, 3B) eine Vielzahl von Unterschichten (3An, 3Bn) mit verschiedenen Bandabstands-Energien umfassen.

9. Der Halbleiterlaser von Anspruch 8, worin die Bandabstands-Energie schrittweise von der aktiven Schicht (4) zur distalen Oberfläche der angrenzenden optischen Begrenzungsschicht (3A, 3B) zunimmt.

10. Der Halbleiterlaser von Anspruch 9, der weiter obere und untere Mantelschichten (2A, 2B) umfasst, die angrenzend an die optischen Begrenzungsschichten geformt sind, worin die Bandabstands-Energie der Mantelschichten (2A, 2B) höher ist als der Bandabstand, sowohl der aktiven Schicht (4) als auch der angrenzenden optischen Begrenzungsschichten (3A, 3B).

11. Der Halbleiterlaser von Anspruch 10, worin die Bandabstands-Energie an den Grenzflächen (A0', A1, A2, A0) zwischen den verschiedenen benachbarten Schichten eine Bandabstands-Enveloppe bestimmt und worin die Bandabstands-Enveloppe eine gerade Linie ist.

12. Der Halbleiterlaser von Anspruch 10, worin die Bandabstands-Energie an den Grenzflächen (A0', A1, A2, A0) zwischen den verschiedenen benachbarten Schichten eine Bandabstands-Enveloppe bestimmt und worin die Bandabstands-Enveloppe eine konvexe Linie ist.

13. Der Halbleiterlaser von Anspruch 12, worin die konvexe Linie im Wesentlichen parabelförmig ist.

14. Der Halbleiterlaser von Anspruch 1, worin die Topfschichten (4A) eine Stauchung zwischen ungefähr 0,5 % und 1,5 % haben.

15. Der Halbleiterlaser von Anspruch 1, worin die Ausgangsfläche (S1) des Laser-Resonators ein Reflexionsvermögen von weniger als ungefähr 5 % hat und die hintere Fläche (S2) ein Reflexionsvermögen von mehr als ungefähr 90 % hat.

16. Der Halbleiterlaser von Anspruch 1, worin die Wellenlänge des Ausgangslichts im Bereich von ungefähr 1200 nm bis ungefähr 1550 nm liegt.

17. Eine Laserkomponente (40), die den Halbleiterlaser von Anspruch 1 einschließt, wobei die Laserkomponente (40) weiter mindestens eine Linse (11b) umfasst, um den Ausgang des Halbleiterlasers (8) optisch mit der Fläche einer optischen Faser (12) zu koppeln, und worin der Halbleiterlaser (8) thermisch mit einer Kühlvorrichtung (9) gekoppelt ist.

18. Die Laserkomponente von Anspruch 17, worin die optische Faser (12) ein darin geformtes Gitter (12b) hat, wobei das Gitter (12b) eine Bandbreite von 3 nm oder weniger hat.

19. Die Laserkomponente von Anspruch 17, worin die optische Faser (12) ein darin geformtes Gitter (12b) hat, wobei das Gitter (12b) eine Bandbreite von 2 nm oder weniger hat.

20. Die Laserkomponente von Anspruch 17, worin die optische Faser (12) ein darin geformtes Gitter (12b) hat, wobei das Gitter (12b) eine Bandbreite von 1,5 nm oder weniger hat.

21. Eine Laserkomponente (40), die den Halbleiterlaser von Anspruch 1 einschließt, wobei die Laserkomponente weiter einen Isolator umfasst, eine Linse (11b) zur optischen Kopplung der Ausgabe des Halbleiterlasers (8) mit der Fläche einer optischen Faser (12), und worin der Halbleiterlaser (8) thermisch mit einer Kühlvorrichtung (9) gekoppelt ist.

22. Ein Halbleiterlaser mit hoher optischer Ausgangsleistung, der einen Halbleiterlaser gemäß Anspruch 1 umfasst, worin:
die mindestens eine der Topfschichten (4A) und die mindestens eine angrenzende Sperrschicht (4B) mit einem Dotierungsmaterial des n-Typs in einer Konzentration von ungefähr 1 x 10¹⁷ bis ungefähr 3 x 10¹⁸ cm⁻³ dotiert sind;
jede der optischen Begrenzungsschichten (3A, 3B) eine Vielzahl von Unterschichten (3An, 3Bn) umfasst, sodass die Unterschichten (3An, 3Bn) eine Bandabstands-Energie haben, die von der aktiven Schicht (4) schrittweise ansteigt, wobei die optischen Begrenzungsschichten (3A, 3B) symmetrisch um die aktive Schicht (4) herum angeordnet sind;
obere und untere Mantelschichten (2A, 2B), die angrenzend zur oberen bzw. unteren optischen Begrenzungsschicht (3A, 3B) geformt sind, wobei die obere und die untere Mantelschicht (2A, 2B) eine Bandabstands-Energie haben, die höher ist als die Bandabstands-Energie der angrenzenden optischen Begrenzungsschichten (3A, 3B);
und worin die Vertiefung eine Antireflexschicht mit einem Reflexionsvermögen von weniger als ungefähr 5 % an einer Ausgangsfläche (S1) davon hat, und eine Reflexionsschicht mit einem Reflexionsvermögen von mehr als ungefähr 90 % an einer hinteren Fläche (S2) davon.

## Revendications

1. Laser à semiconducteur comprenant :
une couche électroluminescente active (4) ayant une structure de puits multiquantiques comprenant une pluralité de couches de puits semiconductrices individuelles (4A) formées entre des couches d'arrêt semiconductrices adjacentes (4B), au moins l'une desdites couches de puits (4A) et au moins l'une desdites couches d'arrêt adjacentes (4B) étant dopées, et
des couches de confinement optique supérieure (3B) et inférieure (3A) adjacentes à ladite couche active (4),
**caractérisé en ce que** ladite structure de puits multiquantiques a une longueur (L) de cavité supérieure à environ 800 *µ*m et l'épaisseur de chacune
desdites couches de confinement optique (3A), (3B) se trouve entre 20 à 50 nm.

2. Laser à semiconducteur de la revendication 1, dans lequel ladite couche de puits (4A) et ladite couche d'arrêt adjacente (4B) sont dopées avec un dopant de type n.

3. Laser à semiconducteur de la revendication 1, dans lequel ladite couche de puits (4A) et ladite couche d'arrêt (4B) sont dopées avec un dopant de type n à une concentration d'environ 1x10¹⁷ à environ 3x10¹⁸ cm⁻³.

4. Laser à semiconducteur de la revendication 3, dans lequel ledit dopant de type n est choisi parmi le groupe constitué de sélénium, soufre et silicium.

5. Laser à semiconducteur de la revendication 1, dans lequel la longueur (L) de la cavité est supérieure à environ 1000 *µ*m.

6. Laser à semiconducteur de la revendication 1, dans lequel une pluralité de couches de puits (4A) et de couches d'arrêt adjacentes (4B) sont dopées avec un dopant de type n.

7. Laser à semiconducteur de la revendication 6, dans lequel toutes les couches de puits (4A) et toutes les couches d'arrêt (4B) sont dopées avec un dopant de type n.

8. Laser à semiconducteur de la revendication 1, dans lequel lesdites couches de confinement optique (3A, 3B) comprennent une pluralité de sous-couches (3An, 3Bn) ayant différentes énergies de bandes interdites.

9. Laser à semiconducteur de la revendication 8, dans lequel l'énergie de bande interdite augmente d'une manière échelonnée à partir de la couche active (4) vers la surface distale de la couche de confinement optique adjacente (3A, 3B).

10. Laser à semiconducteur de la revendication 9, comprenant de plus des couches de gaine supérieure et inférieure (2A, 2B) formées de façon adjacente auxdites couches de confinement optique, dans lequel l'énergie de bande interdite des couches de gaine (2A, 2B) est supérieure à la bande interdite à la fois de la couche active (4) et des couches de confinement optique adjacentes (3A, 3B).

11. Laser à semiconducteur de la revendication 10, dans lequel les énergies de bandes interdites au niveau des limites (A0', A1, A2, A0) entre les différentes couches adjacentes définissent une enveloppe de bande interdite, et dans lequel ladite enveloppe de bande interdite est une ligne droite.

12. Laser à semiconducteur de la revendication 10, dans lequel les énergies de bandes interdites au niveau des limites (A0', A1, A2, A0) entre les différentes couches adjacentes définissent une enveloppe de bande interdite, et dans lequel ladite enveloppe de bande interdite est une ligne convexe.

13. Laser à semiconducteur de la revendication 12, dans lequel ladite ligne convexe est sensiblement parabolique.

14. Laser à semiconducteur de la revendication 1, dans lequel les couches de puits (4A) ont une déformation en compression entre environ 0,5% et 1,5%.

15. Laser à semiconducteur de la revendication 1, dans lequel la facette de sortie (S1) de la cavité du laser a une réflectivité inférieure à environ 5%, et la facette arrière (S2) a une réflectivité supérieure à environ 90%.

16. Laser à semiconducteur de la revendication 1, dans lequel la longueur d'onde de la lumière de sortie est dans la plage d'environ 1200 nm à environ 1550 nm.

17. Composant laser (40) incorporant le laser à semiconducteur de la revendication 1, ledit composant laser (40) comprenant de plus au moins une lentille (11B) pour coupler optiquement la sortie dudit laser à semiconducteur (8) à la facette d'une fibre optique (12) et dans lequel ledit laser à semiconducteur (8) est thermiquement couplé à un dispositif de refroidissement (9).

18. Composant laser de la revendication 17, dans lequel ladite fibre optique (12) a un réseau (12b) formé dans celle-ci, ledit réseau (12b) ayant une largeur de bande de 3 nm ou moins.

19. Composant laser de la revendication 17, dans lequel ladite fibre optique (12) a un réseau (12b) formé dans celle-ci, ledit réseau (12b) ayant une largeur de bande de 2 nm ou moins.

20. Composant laser de la revendication 17, dans lequel ladite fibre optique (12) a un réseau (12b) formé dans celle-ci, ledit réseau (12b) ayant une largeur de bande de 1,5 nm ou moins.

21. Composant laser (40) incorporant le laser à semiconducteur de la revendication 1, ledit composant laser comprenant de plus un isolant, une lentille (11b) pour coupler optiquement la sortie dudit laser à semiconducteur (8) à la facette d'une fibre optique (12) et dans lequel ledit laser à semiconducteur (8) est couplé thermiquement à un dispositif de refroidissement (9).

22. Laser à semiconducteur à puissance de sortie optique élevée, comprenant un laser à semiconducteur selon la revendication 1, dans lequel :
ladite des couches de puits (4A) et ladite des couches de barrière adjacentes (4B) sont dopées avec un dopant de type n à une concentration d'environ 1x10¹⁷ à environ 3x10¹⁸ cm⁻³;
chacune desdites couches de confinement optique (3A, 3B) comprend une pluralité de sous-couches (3An, 3Bn), de telle sorte que lesdites sous-couches (3An, 3Bn) ont une énergie de bande interdite qui augmente de façon échelonnée à partir de ladite couche active (4), lesdites couches de confinement optique (3A, 3B) étant disposées symétriquement autour de ladite couche active (4) ;
des couches de gaine supérieure et inférieure (2A, 2B) formées de façon adjacente auxdites couches de confinement optique supérieure et inférieure (3A, 3B), respectivement, lesdites couches de gaine ayant une énergie de bande interdite supérieure à l'énergie de bande interdite desdites couches adjacentes de confinement optique (3A, 3B);
et dans lequel ladite cavité a un revêtement antiréflecteur ayant une réflectivité inférieure à environ 5% sur une facette de sortie (S1) de celui-ci, et un revêtement réflecteur ayant une réflectivité supérieure à environ 90% sur une facette arrière (S2) de celui-ci.
